# EUROPÄISCHE PATENTSCHRIFT

(11) **EP 4 016 783 B1**
(45) Veröffentlichungstag und Bekanntmachung des Hinweises auf die Patenterteilung: **22.11.2023**
(21) Anmeldenummer: 20214339.2
(22) Anmeldetag: 15.12.2020
(51) Int. Cl.: H02J 7/00

(54) **LADEGERÄT MIT LADEELEKTRONIKEINHEIT UND KÜHLLUFTFÜHRUNGSSTRUKTUR**
CHARGER WITH CHARGING ELECTRONICS UNIT AND COOLING AIR GUIDING STRUCTURE
CHARGEUR POURVU D'UNITÉ D'ÉLECTRONIQUE DE CHARGE ET STRUCTURE DE GUIDAGE D'AIR DE REFROIDISSEMENT

(43) Veröffentlichungstag der Anmeldung: 22.06.2022
(73) Patentinhaber: Andreas Stihl AG & Co. KG, 71336 Waiblingen (DE)
(72) Erfinder: Fuchs, Michael, 71332 Waiblingen (DE); Mattheis, Leonard, 71336 Waiblingen (DE); Hellmann, Charis, 70825 Korntal-Münchingen (DE); Müller, Markus, 73635 Rudersberg (DE)
(74) Vertreter: Patentanwälte Ruff, Wilhelm, Beier, Dauster & Partner mbB

(56) Entgegenhaltungen:
- EP-A1- 1 475 876
- DE-T5-112016 002 974
- US-A1- 2008 290 836

## Beschreibung

Die Erfindung bezieht sich auf ein Ladegerät, das ein Gerätegehäuse mit mindestens einem von außen zur Positionierung einer wiederaufladbaren Batterieeinheit zugänglichen Batterieladeplatz, eine Ladeelektronikeinheit im Gerätegehäuse zur Steuerung eines elektrischen Ladevorgangs für die am Batterieladeplatz positionierte Batterieeinheit und eine Kühlluftführungsstruktur umfasst, die zur Führung einer Kühlluftströmung von einer Lufteinlassstruktur des Gerätegehäuses über die Ladeelektronikeinheit zu einer Luftauslassstruktur des Gerätegehäuses eingerichtet ist.

Derartige Ladegeräte, genauer gesagt elektrische Ladegeräte, dienen zum Laden, i.e. elektrischen Aufladen, einer jeweiligen wiederaufladbaren elektrischen Batterieeinheit, die dazu in den Batterieladeplatz eingebracht bzw. an diesem angeordnet wird. Aus diesem kann sie dann wieder an der Bedienseite des Ladegerätgehäuses entnommen werden, insbesondere nach erfolgter Aufladung. Das Ladegerät kann als Einzelplatzladegerät, das einen einzigen Batterieladeplatz aufweist, oder als Mehrplatzladegerät ausgeführt sein, das über mehrere Batterieladeplätze verfügt. Der Begriff Batterieeinheit umfasst vorliegend einen elektrischen Energiespeicher jedweden herkömmlichen Batterietyps, insbesondere vom Typ sogenannter Akkupacks, wie sie zur elektrischen Energieversorgung beispielsweise von elektrisch betriebenen Garten- und Forstbearbeitungsgeräten sowie elektrisch betriebenen Heimwerkergeräten bzw. Handwerkzeuggeräten vielfach zum Einsatz kommen.

Die Ladeelektronikeinheit steuert die elektrischen Ladevorgänge für die an dem oder den Batterieladeplätzen angeordneten Batterieeinheiten und ist hierfür in jeweils geeigneter herkömmlicher Weise realisiert, z.B. unter Verwendung von Steuerungskomponenten, wie eines Mikrocontrollers oder dgl., und ladestromführenden Komponenten, z.B. unter Verwendung eines hierfür gängigen Leistungselektronikteils. Oftmals beinhaltet die Ladeelektronikeinheit eine oder mehrere Platinen, auf denen sich die betreffenden Komponenten befinden.

Die Kühlluftführungsstruktur dient dazu, Kühlluft durch das Gerätegehäuse hindurch zu leiten und diese dabei insbesondere über die Ladeelektronikeinheit hinweg zu führen, um je nach Bedarf die Ladeelektronikeinheit insgesamt eine oder einen oder mehrere Bestandteile derselben zu kühlen. Die Kühlluft gelangt dazu über die Lufteinlassstruktur in das Gerätegehäuse und über dessen Luftauslassstruktur wieder aus dem Gerätegehäuse hinaus. Die Lufteinlassstruktur und die Luftauslassstruktur des Gerätegehäuses können von beliebiger geeigneter Art sein, z.B. als jeweils ein oder mehrere beabstandet voneinander angeordnete Einlass- bzw. Auslassschlitzbereiche.

Die Offenlegungsschrift US 2019/0199101 A1 offenbart ein Ladegerät dieser Art, bei dem in einem quaderförmigen Gerätegehäuse zwei in als jeweilige Platine ausgeführte Ladeelektronikeinheiten in einer gespiegelten Anordnung nebeneinander angeordnet sind und die Kühlluftführungsstruktur zur Führung zweier unabhängiger Kühlluftströmungen über die jeweilige Ladeelektronikeinheit hinweg eingerichtet ist und dazu als Lufteinlassstruktur je zwei Lufteinlassschlitzzonen an benachbarten Seiten des Gerätegehäuses und als Luftauslassstruktur je eine Luftauslassschlitzzone aufweist, die an einer weiteren Seite gebildet ist, wobei je ein Lüfter angrenzend an die jeweilige Luftauslassschlitzzone an der Innenseite des Gerätegehäuses angeordnet ist. Die Kühlluftführungsstruktur ist dafür ausgelegt, die jeweilige Kühlluftströmung primär über einen Teilbereich der zugeordneten Platine zu führen, in dem sich wärmeerzeugende Komponenten befinden, während ein restlicher Platinenbereich kaum von der Kühlluftströmung erfasst wird.

Die Offenlegungsschrift EP 3 327 888 A1 offenbart ein Ladegerät dieser Art, bei dem die Kühlluftführungsstruktur dafür eingerichtet ist, die Kühlluftströmung zunächst durch eine am Batterieladeplatz angeordnete Batterieeinheit zu führen, wozu diese über eine eigene Lufteinlassstruktur verfügt, und anschließend durch das Gerätegehäuse hindurchzuführen, wozu sich die Lufteinlassstruktur des Gerätegehäuses im Bereich des Batterieladeplatzes befindet. Im Gerätegehäuse ist ein gerichteter, rohrförmiger Luftkanal gebildet, in dem ein Lüfter angeordnet ist, wobei von der Kühlluftströmung in diesem Strömungskanal die als Platine realisierte Ladeelektronikeinheit angeströmt wird.

Die Offenlegungsschrift DE 11 2016 002 974 T5 offenbart ein weiteres Ladegerät der eingangs genannten Art, bei dem im Gerätegehäuse ein Lüfter relativ großer Leistung oder zwei Lüfter jeweils direkt vor einem von zwei die Luftauslassstruktur bildenden Luftauslassschlitzbereichen an zwei benachbarten Gerätegehäuseseiten angeordnet ist/sind und die Ladeelektronikeinheit in Form einer Platine offen im Gerätegehäuse derart angeordnet ist, dass die von der Kühlluftführungsstruktur bereitgestellte Kühlluftströmung über die Platine hinweg geführt wird, wobei die Lufteinlassstruktur des Gerätegehäuses einen an einer weiteren Gehäuseseite befindlichen Lufteinlassschlitzbereich beinhaltet.

Auch bei dem in der Offenlegungsschrift US 2018/0337540 A1 offenbarten Ladegerät dieser Art ist die Ladeelektronikeinheit offen als Platine im Gerätegehäuse angeordnet, und die Kühlluftführungsstruktur führt die Kühlluftströmung über diese Platine hinweg von einem Lufteinlassschlitzbereich des Gerätegehäuses zu einem an einer gegenüberliegenden Gehäuseseite gebildeten Luftauslassschlitzbereich, vor dem ein zugehöriger Lüfter angeordnet ist. Des Weiteren ist die dortige Kühlluftführungsstruktur zur zusätzlichen Kühlung einer am Batterieladeplatz befindlichen Batterieeinheit mittels einer weiteren Kühlluftströmung eingerichtet, für die ein weiterer Lufteinlassschlitzbereich des Gerätegehäuses, ein weiterer Lüfter und ein weiterer Luftauslassschlitzbereich des Gerätegehäuses vorgesehen sind, wobei der weitere Luftauslassschlitzbereich am Batterieladeplatz mündet, um die betreffende Kühlluftströmung zur dort platzierten Batterieeinheit zu leiten. EP1475876A1 und US2008/290836 A1 offenbaren ebenso weitere Ladungsgeräte.

Der Erfindung liegt als technisches Problem die Bereitstellung eines Ladegerätes der eingangs genannten Art zugrunde, das sich mit vergleichsweise geringem Aufwand realisieren lässt und gegenüber dem oben erwähnten Stand der Technik insbesondere hinsichtlich seiner Kühlfunktionalität verbessert ist.

Die Erfindung löst dieses Problem durch die Bereitstellung eines Ladegerätes mit den Merkmalen des Anspruchs 1. Vorteilhafte Weiterbildungen der Erfindung, die zur Lösung dieses und weiterer Probleme beitragen, sind in den Unteransprüchen angegeben, deren Inhalt einschließlich sämtlicher sich durch die Anspruchsrückbezüge ergebender Merkmalskombinationen hiermit vollumfänglich durch Verweis zum Inhalt der Beschreibung gemacht wird.

Beim erfindungsgemäßen Ladegerät beinhaltet die Kühlluftführungsstruktur ein im Inneren des Gerätegehäuses angeordnetes Kühlungsgehäuse, das eine Kühlungsgehäuse-Lufteinlassstruktur und eine Kühlungsgehäuse-Luftauslassstruktur aufweist, und ist zur Führung der Kühlluftströmung durch das Kühlungsgehäuse hindurch von der Kühlungsgehäuse-Lufteinlassstruktur zu der Kühlungsgehäuse-Luftauslasssstruktur und von dieser zur Luftauslassstruktur des Gerätegehäuses eingerichtet. Die Ladeelektronikeinheit weist mindestens eine im Kühlungsgehäuse angeordnete Elektronickomponente auf.

Die Lufteinlassstruktur und die Luftauslassstruktur des Kühlungsgehäuses können von beliebiger herkömmlicher Art sein, z.B. als jeweils eine oder mehrere lokalisiert und beabstandet voneinander angeordnete Einlass- bzw. Auslassschlitzbereiche und/oder Einlass- bzw. Auslassbohrungen. Die Lufteinlassstruktur und die Luftauslassstruktur des Gerätegehäuses können analog von beliebiger geeigneter Art sein, z.B. als jeweils eine oder mehrere lokalisiert und beabstandet voneinander angeordnete Einlass- bzw. Auslassschlitzbereiche und/oder Einlass- bzw. Auslassbohrungen und/oder als bewusst belassene Luftundichtigkeiten an einer oder mehreren Stellen des Gerätegehäuses, wie zwischen aneinandergrenzenden Gehäuseteilen und/oder im Bereich des Batterieladeplatzes.

Durch die erfindungsgemäße Anordnung der Elektronikkomponente der Ladeelektronikeinheit im Kühlungsgehäuse innerhalb des Gerätegehäuses schützt das Kühlungsgehäuse die Elektronikkomponente vor äußeren Einflüssen, die im Gerätegehäuse vorliegen können. So kann die Elektronikkomponente durch das Kühlungsgehäuse z.B. zusätzlich vor in das Gerätegehäuse gelangendem Schmutz geschützt werden. Umgekehrt kann das Kühlungsgehäuse den restlichen Innenraum des Gerätegehäuses vor unerwünschten Einflüssen durch die Elektronikkomponente schützen, z.B. vor thermischen Einflüssen durch von der Elektronikkomponente abgegebene Wärme.

Gleichzeitig trägt das Kühlungsgehäuse als Bestandteil der Kühlluftführungsstruktur zur Führung der Kühlluftströmung bei, wozu es die zugehörige Lufteinlassstruktur und die zugehörige Luftauslassstruktur besitzt und im Übrigen als Begrenzung für die Kühlluftströmung durch das Kühlungsgehäuse hindurch fungieren kann, so dass die im Kühlungsgehäuse angeordnete Elektronikkomponente gezielt dem Einfluss der Kühlluftströmung unterworfen und auf diese Weise durch die Kühlluftströmung bei Bedarf gekühlt werden kann. Das Vorhandensein des Kühlungsgehäuses trägt dazu bei, dass die Kühlluftströmung gerichteter und effektiver über die Elektronikkomponente hinweggeführt werden kann als in herkömmlichen Anordnungen, in denen die Ladeelektronikeinheit z.B. als mit dem zugehörigen Komponenten bestückte Platine offen im Innenraum des Ladegerätgehäuses platziert ist.

In einer Weiterbildung der Erfindung sind die Kühlungsgehäuse-Lufteinlassstruktur und die Kühlungsgehäuse-Luftauslassstruktur jeweils lokal an zwei unterschiedlichen Seiten- oder Eckbereichen des Kühlungsgehäuses ausgebildet. Diese aufeinander abgestimmte Platzierung von Lufteinlassstruktur einerseits und Luftauslassstruktur andererseits lokalisiert in Bereichen an zwei unterschiedlichen Seiten oder Ecken des Kühlungsgehäuses ermöglicht in entsprechenden Anwendungen eine optimale Führung der Kühlluftströmung durch das Kühlungsgehäuse hindurch. Bei der lokalen Lufteinlassstruktur bzw. Luftauslassstruktur des Kühlungsgehäuses kann es sich insbesondere um eine an sich bekannte Einlassschlitzstruktur bzw. Auslassschlitzstruktur handeln. Diese lokale Trennung von Lufteinlassstruktur und Luftauslassstruktur des Kühlungsgehäuses vermeidet zudem, dass über die Luftauslassstruktur aus dem Kühlungsgehäuse austretende Kühlluft gleich wieder über die Lufteinlassstruktur in das Kühlungsgehäuse hinein gelangt, was die Kühleffektivität verringern könnte. Für entsprechende Anwendungen kann es alternativ günstig sein, die Lufteinlassstruktur und die Luftauslassstruktur des Kühlungsgehäuses auf einer gleichen Seite oder in einem gleichen Eckbereich des Kühlungsgehäuses auszubilden.

In einer Weiterbildung der Erfindung ist das Kühlungsgehäuse brandschutzsicher ausgeführt. In diesem Fall hat das Kühlungsgehäuse die zusätzliche Funktion, das restliche Ladegerätgehäuse vor unerwünschten thermischen Einflüssen zu schützen, die in entsprechenden Betriebssituationen bei einer übermäßigen Aufheizung der im Kühlungsgehäuse angeordneten Elektronikkomponente entstehen können. Insbesondere bietet das Kühlungsgehäuse einen Brandschutz, wie er oftmals für Elektronickomponenten gewünscht oder gefordert ist, die sich in ungünstigen Situationen bzw. bei Fehlfunktion übermäßig aufheizen und die Gefahr entstehen lassen können, dass umgebendes Material in Brand gerät. Mit diesem Brandschutz durch das Kühlungsgehäuse entfällt die Notwendigkeit, das Ladegerätgehäuse selbst brandschutzsicher auszuführen, d.h. für das Ladegerätgehäuse können auch Materialien verwendet werden, die bestimmte Brandschutzeigenschaften nicht erfüllen. Hierbei ist vorliegend unter einer brandschutzsicheren Ausführung insbesondere zu verstehen, dass das betreffende Material eine Temperaturbeständigkeit bis zu mindestens ca. 850°C besitzt, ohne in Brand zu geraten. Alternativ ist das Kühlungsgehäuse nicht brandschutzsicher ausgeführt, z.B. für Anwendungen, in denen keine brandschutzsichere Ausführung des Ladegerätes erforderlich ist oder in denen das Ladegerätgehäuse selbst brandschutzsicher ausgeführt ist.

In einer Weiterbildung der Erfindung weist die Ladeelektronikeinheit mindestens eine weitere Elektronikkomponente auf, die sich außerhalb des Kühlungsgehäuses befindet. Dies stellt eine für entsprechende Anwendungen günstige Aufteilung der Ladeelektronikeinheit dar. Mindestens eine Elektronikkomponente ist im Kühlungsgehäuse geschützt untergebracht und der Kühlluftströmung durch das Kühlungsgehäuse hindurch unterworfen, mindestens eine andere Elektronikkomponente ist außerhalb des Kühlungsgehäuses platziert, wobei es sich bei dieser letztgenannten Elektronikkomponente insbesondere um eine solche handeln kann, die im Betrieb keine oder nur eine relativ geringe Wärmentwicklung besitzt. Alternativ können alle Elektronikkomponenten der Ladeelektronikeinheit im Kühlungsgehäuse untergebracht sein.

In einer Weiterbildung der Erfindung weist die Ladeelektronikeinheit ein Leistungselektronikteil und/oder ein Umschaltelektronikteil, wie es insbesondere bei Vorhandensein mehrerer Batterieladeplätze zum Umschalten von Aufladevorgängen zwischen den verschiedenen Batterieladeplätzen zweckmäßig sein kann, als im Kühlungsgehäuse angeordnete Elektronikkomponente auf. Mit dieser Maßnahme kann der Leistungselektronikteil bzw. der Umschaltelektronikteil von der Kühlluftströmung im Kühlungsgehäuse effektiv gekühlt werden, was in vielen Fällen deshalb günstig ist, weil es sich hierbei üblicherweise um einen Elektronikteil mit merklicher Wärmeerzeugung im Betrieb handelt. Alternativ kann der Leistungselektronikteil oder der Umschaltelektronikteil außerhalb des Kühlungsgehäuses angeordnet sein, wenn dies in entsprechenden Anwendungen gewünscht und ausreichend ist.

In einer Weiterbildung der Erfindung grenzt das Kühlungsgehäuse mit seiner Kühlungsgehäuse-Luftauslassstruktur an die Luftauslassstruktur des Gerätegehäuses an. Dies koppelt die Luftauslassstruktur des Gerätegehäuses direkt an die Luftauslassstruktur des Kühlungsgehäuses an, was für viele Anwendungen von Vorteil ist. Denn die durch die Elektronikkomponente im Kühlungsgehäuse erwärmte Kühlluftströmung wird auf diese Weise direkt aus dem Gerätegehäuse ausgeleitet, ohne zuvor noch über einen anderen Bereich im Gerätegehäuse zu strömen und diesen zu erwärmen. Alternativ ist die Luftauslassstruktur des Gerätegehäuses mit Abstand zur Luftauslassstruktur des Kühlungsgehäuses angeordnet, wenn dies für entsprechende Anwendungen Vorteile bietet, z.B. weil ein zwischenliegender Bereich des Gerätegehäuses durch die erwärmte Kühlluftströmung erwärmt werden soll.

In einer Weiterbildung der Erfindung beinhaltet die Kühlungsgehäuse-Lufteinlassstruktur zwei Lufteinlasszonen an zwei einander benachbarten Seitenbereichen des Kühlungsgehäuses. Dies stellt eine für entsprechende Anwendungen optimierte Realisierung der Lufteinlassstruktur des Kühlungsgehäuses dar. Es versteht sich, dass der Fall zweier Lufteinlasszonen im Sinne von mindestens zwei Lufteinlasszonen zu verstehen ist, d.h. bei Bedarf können auch drei und mehr Lufteinlasszonen an zwei, drei oder mehr unterschiedlichen Seitenbereichen des Kühlungsgehäuses vorgesehen sein. Die mindestens zwei lokal voneinander getrennten Lufteinlasszonen ermöglichen den Eintritt von Kühlluft an den zwei entsprechenden Seitenbereichen in das Kühlluftgehäuse, wobei die beiden Lufteinlasszonen z.B. von üblichen Lufteinlassschlitzbereichen gebildet sein können. In alternativen Ausführungen beinhaltet die Kühlungsgehäuse-Lufteinlassstruktur je nach Bedarf und Anforderung nur eine einzige Lufteinlasszone an einem zugehörigen Seitenbereich des Kühlungsgehäuses oder zwei Lufteinlasszonen an einer gleichen Seite oder an gegenüberliegenden Seiten des Kühlungsgehäuses.

In einer Weiterbildung der Erfindung weist das Kühlungsgehäuse zwei gegenüberliegende Hauptseiten und einen diese verbindenden Schmalseitenumfang auf, und die Kühlungsgehäuse-Lufteinlassstruktur sowie die Kühlungsgehäuse-Luftauslassstruktur sind am Schmalseitenumfang ausgebildet. Diese Realisierung erweist sich für viele Anwendungsfälle als optimal, indem die Kühlluft schmalseitig in das Kühlungsgehäuse gelangt und auch schmalseitig wieder aus diesem austritt, so dass die Kühlluftströmung dazwischen effektiv zwischen den gegenüberliegenden Hauptseiten im Wesentlichen parallel zu diesen strömen kann, beispielsweise ohne dass eine Strömungsumlenkung um 90° oder mehr in Bezug auf die Hauptseitenebenen erforderlich ist. In alternativen Ausführungen kann es von Vorteil sein, die Lufteinlassstruktur und/oder die Luftauslassstruktur des Kühlungsgehäuses an einer jeweiligen Hauptseite desselben auszubilden.

In einer Weiterbildung der Erfindung ist die im Kühlungsgehäuse angeordnete Elektronikkomponente speziell an einer von zwei gegenüberliegenden Hauptseiten des Kühlungsgehäuses angeordnet. Dies kann zu einer Optimierung der Platzierung der Elektronikkomponente im Kühlungsgehäuse und deren Kühlung durch die Kühlluftströmung beitragen. Insbesondere umfasst diese Ausgestaltung die Möglichkeit, bei Realisierungen der Ladeelektronikeinheit mit einer Platine diese Platine als eine der beiden Hauptseiten des Kühlungsgehäuses zu benutzen, so dass eine auf der Platine montierte Elektronikkomponente an der betreffenden Innenseite des Kühlungsgehäuses angeordnet ist. Der restliche Teil des Kühlungsgehäuses bildet in diesem Fall quasi eine mit der Platine verbundene Gehäusehaube, die z.B. auf die Platine aufgesetzt und an dieser fixiert sein kann. Alternativ kann die Platine der Ladeelektronikeinheit im Inneren des Kühlungsgehäuses angeordnet sein, ohne eine Gehäusewand desselben zu bilden, wenn dies für entsprechende Anwendungen von Vorteil ist.

In einer Weiterbildung der Erfindung weist die Kühlluftführungsstruktur einen Lüfter auf, der stromaufwärts oder stromabwärts angrenzend an die Kühlungsgehäuse-Luftauslassstruktur angeordnet ist. Diese Positionierung des Lüfters ist für viele Anwendungsfälle optimal, sowohl unter strömungstechnischen Gesichtspunkten als auch hinsichtlich Montage- und Fertigungsaufwand sowie Bauform des Kühlungsgehäuses bzw. des Ladegerätgehäuses. Dabei kann der Lüfter z.B. am Kühlungsgehäuse selbst oder alternativ an der Luftauslassstruktur des Ladegerätgehäuses direkt angrenzend an die Kühlungsgehäuse-Luftauslassstruktur angebracht sein. Alternativ kann der Lüfter an anderer Stelle angeordnet sein, wenn dies für entsprechende Anwendungen günstig ist, z.B. stromaufwärts oder stromabwärts angrenzend an die Kühlungsgehäuse-Lufteinlassstruktur.

In einer Weiterbildung der Erfindung ist die Lufteinlassstruktur des Gerätegehäuses als delokalisierte Lufteinlassstruktur ausgeführt und weist eine Mehrzahl von Lufteinlässen auf, die an mindestens einem Seitenbereich des Gerätegehäuses über dessen Bereichsausdehnung hinweg verteilt und/oder an mindestens zwei entgegengesetzten Seitenbereichen des Gerätegehäuses gebildet sind. Unter delokalisierter Lufteinlassstruktur ist hierbei vorliegend zu verstehen, dass die Lufteinlassstruktur nicht ausschließlich aus einem einzigen oder mehreren lokalisierten Lufteinlässen z.B. in Form entsprechender herkömmlicher Lufteinlassschlitzbereiche besteht, sondern mehrere Lufteinlässe an verschiedenen über das Gerätegehäuse hinweg breit verteilten Stellen umfasst. Dazu können auch bewusst belassene Luftundichtigkeiten in einer Gehäusewand oder zwischen zwei aneinandergrenzenden Gehäusewänden des Gerätegehäuses gehören. Dies schließt die Möglichkeit ein, dass entsprechende Luftundichtigkeitsspalte im Bereich des oder der Batterieladeplätze gebildet sind, z.B. in einem Eintrittsbereich und/oder einem entgegengesetzten Batteriekontaktbereich eines den Batterieladeplatz bildenden Batterieschachtbereichs des Ladegerätgehäuses. Die solchermaßen delokalisierte Lufteinlassstruktur hat dementsprechend eine lokal verteilte, diffuse Lufteinlasscharakteristik für das Gerätegehäuse zur Folge, so dass im Gerätegehäuse außerhalb des Kühlungsgehäuses die Kühlluft nicht als definiert gerichtete Strömung, sondern als eher diffuse, ungerichtete Strömung strömt. Dies erweist sich für viele Anwendungsfälle als günstig. Alternativ kann eine definierte, gerichtete Kühlluftführung auch im Ladegerätgehäuse außerhalb des Kühlungsgehäuses vorgesehen sein, wenn dies für entsprechende Anwendungen von Vorteil ist.

In einer Ausgestaltung der Erfindung befindet sich zumindest einer der Lufteinlässe an einer in einer Gebrauchslage des Gerätegehäuses untenliegenden Seite des Gerätegehäuses und bildet eine Wasserauslassöffnung. Dies ermöglicht eine vorteilhafte Doppelnutzung der entsprechenden Durchbrechung im Gerätegehäuse sowohl als Lufteinlass in das Gerätegehäuse als auch als Auslassöffnung, über die in das Gerätegehäuse eingedrungenes oder im Gerätegehäuse z.B. durch den Kondensation gebildetes Wasser aus dem Gerätegehäuse abfließen kann, wenn sich das Gerätegehäuse in der Gebrauchslage befindet. Unter Gebrauchslage ist dabei diejenige räumliche Lageorientierung des Gerätegehäuses zu verstehen, in der es sich üblicherweise und bestimmungsgemäß befindet, wenn das Ladegerät in Betrieb ist. In alternativen Ausführungen fehlt den Lufteinlässen diese Zusatzfunktion als Öffnungen zum Ableiten von Wasser in der Gebrauchslage des Gerätegehäuses.

Vorteilhafte Ausführungsformen der Erfindung sind in den Zeichnungen dargestellt. Diese und weitere Ausführungsformen der Erfindung werden nachfolgend näher erläutert. Hierbei zeigen:
- Fig. 1: eine Perspektivansicht eines Ladegeräts schräg von oben mit einem Ladegerätgehäuse mit unterer und oberer Gehäuseschale in einer Gebrauchslage des Ladegeräts,
- Fig. 2: eine Schnittansicht des Ladegeräts längs einer Linie II-II in Fig. 1,
- Fig. 3: eine Perspektivansicht einer im Ladegerätgehäuse untergebrachten Ladeelektronikeinheit mit Kühlungsgehäuse,
- Fig. 4: eine Perspektivansicht des Ladegeräts schräg von unten,
- Fig. 5: eine Längsschnittansicht eines Batterieladeplatzes des Ladegerätgehäuses,
- Fig. 6: eine Draufsicht auf den Batterieladeplatz mit einer eingesetzten Batterieeinheit,
- Fig. 7: eine Detailschnittansicht eines unteren Bereichs eines Batterieladeplatzes des Ladegerätgehäuses,
- Fig. 8: eine Perspektivansicht des Ladegeräts schräg von unten ohne untere Gehäuseschale und
- Fig. 9: eine Perspektivansicht des Ladegeräts schräg von oben mit hältig weggeschnittener oberer Gehäuseschale und ohne untere Gehäuseschale.

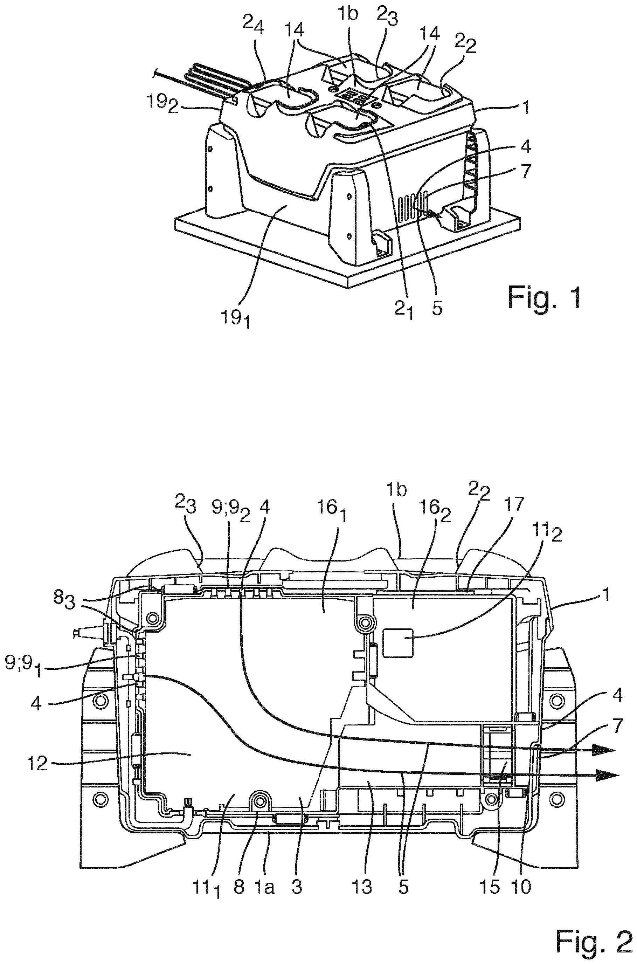

Das erfindungsgemäße, in den Figuren exemplarisch in einer möglichen Ausführungsform gezeigte Ladegerät beinhaltet ein Gerätegehäuse 1 mit mindestens einem von außen zur Positionierung einer wiederaufladbaren Batterieeinheit zugänglichen Batterieladeplatz, im gezeigten Beispiel vier Batterieladeplätzen 2₁, 2₂, 2₃, 2₄, und eine Ladeelektronikeinheit 3 zur Steuerung eines elektrischen Ladevorgangs für die am jeweiligen Batterieladeplatz 2₁ bis 2₄ positionierte Batterieeinheit. Fig. 1 zeigt das Ladegerät mit vier in die vier Batterieladeplätze 2₁ bis 2₄ eingefügten Batterieeinheiten 14. Im Gerätegehäuse 1 befindet sich eine Ladeelektronikeinheit 3 zur Steuerung eines elektrischen Ladevorgangs für die am jeweiligen Batterieladeplatz 2₁ bis 2₄ positionierte Batterieeinheit 14.

Weiter beinhaltet das Ladegerät eine Kühlluftführungsstruktur 4, die zur Führung einer Kühlluftströmung 5 von einer Lufteinlassstruktur 6 des Gerätegehäuses 1 über die Ladeelektronikeinheit 3 zu einer Luftauslassstruktur 7 des Gerätegehäuses 1 eingerichtet ist. Die Kühlluftführungsstruktur 4 beinhaltet ein im Inneren des Gerätegehäuses 1 angeordnetes Kühlungsgehäuse 8, das eine Kühlungsgehäuse-Lufteinlassstruktur 9 und eine Kühlungsgehäuse-Luftauslassstruktur 10 aufweist.

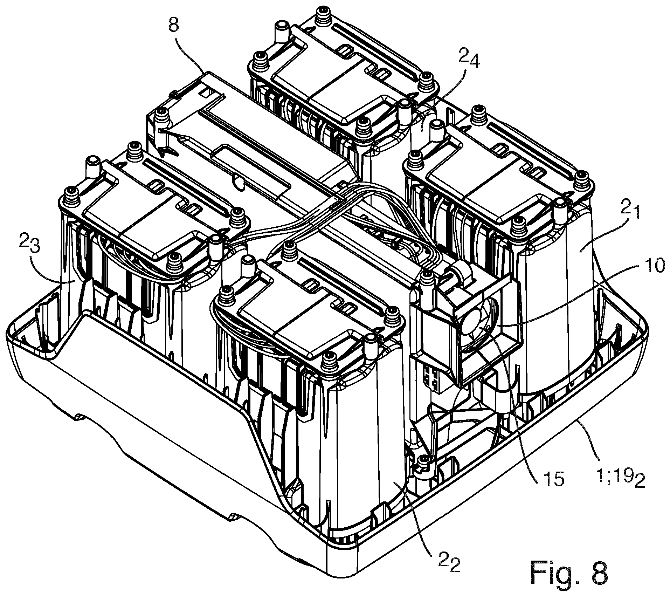

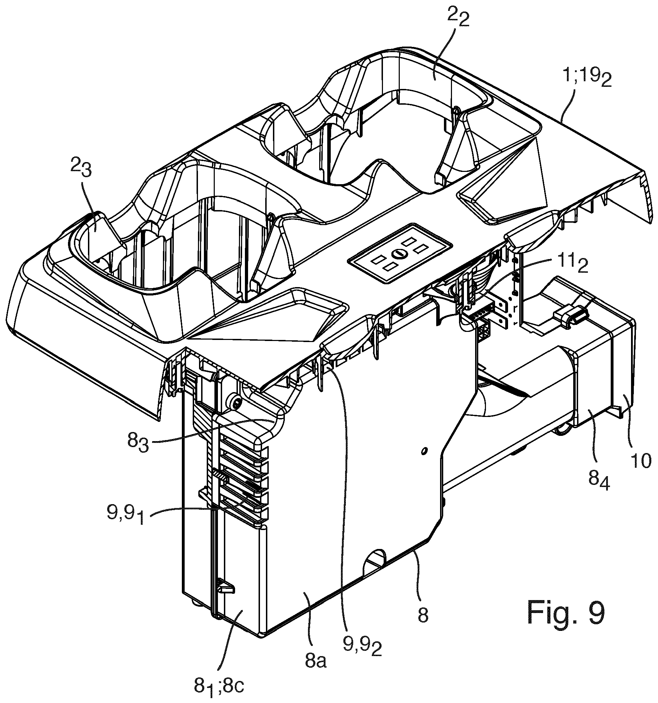

Im gezeigten Beispiel ist das Gerätegehäuse quaderförmig gestaltet, d.h. mit viereckigem Querschnitt, insbesondere etwa würfelförmig. In alternativen Ausführungen hat das Gerätegehäuse 1 eine andere Gestalt, z.B. mit rundem oder ovalem Querschnitt oder einem polygonalen Querschnitt mit mehr als vier Ecken. Im gezeigten Beispiel sind die vier Batterieladeplätze 2₁ bis 2₄ in einer Viereckkonstellation angeordnet, wie z.B. aus den Fig. 1 und 8 ersichtlich. Das Kühlungsgehäuse 8 ist etwa mittig im Gerätegehäuse 1 zwischen je zwei der vier Batterieladeplätze 2₁ bis 2₄ positioniert und erstreckt sich im Wesentlichen über fast die gesamte Länge und zumindest abschnittweise über fast die gesamte Höhe des Gerätegehäuses 1, wie insbesondere aus den Fig. 8 und 9 ersichtlich. Dabei verlaufen Außenseiten des Kühlungsgehäuses 8 etwa parallel zu Außenseiten des Gerätegehäuses 1.

Die Kühlluftführungsstruktur 4 ist zur Führung der Kühlluftströmung 5 durch das Kühlungsgehäuse 8 hindurch von der Kühlungsgehäuse-Lufteinlassstruktur 9 zu der Kühlungsgehäuse-Luftauslassstruktur 10 und von dieser zur Luftauslassstruktur 7 eingerichtet. Die Ladeelektronikeinheit 3 weist mindestens eine im Kühlungsgehäuse 8 angeordnete Elektronikkomponente 11₁ auf, wie in Fig. 2 schematisch dargestellt.

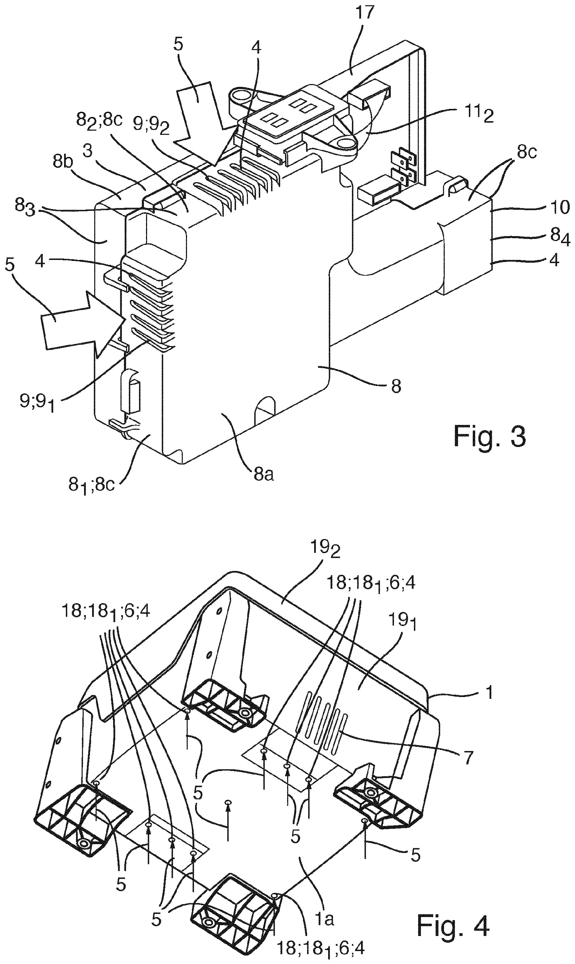

In entsprechenden Realisierungen sind die Kühlungsgehäuse-Lufteinlassstruktur 9 und die Kühlungsgehäuse-Luftauslassstruktur 10, wie im gezeigten Beispiel, jeweils lokal an zwei unterschiedlichen Seiten- oder Eckbereichen des Kühlungsgehäuses 8 ausgebildet. Im gezeigten Beispiel sind die Lufteinlassstruktur 9 des Kühlungsgehäuses 8 an einem in den Fig. 2 und 3 linken oberen Seiten-/Eckbereich 8₃ und die Luftauslassstruktur 10 entgegengesetzt an einem in den Fig. 2 und 3 rechten unteren Seiten-/Eckbereich 8₄ des Kühlungsgehäuses 8 ausgebildet. Dadurch kann die Kühlluftströmung 5 optimal quasi längs bzw. diagonal durch das gesamte Kühlungsgehäuse 8 hindurch strömen.

In vorteilhaften Ausführungen ist das Kühlungsgehäuse 8, wie im gezeigten Beispiel, brandschutzsicher ausgeführt, d.h. das für das Kühlungsgehäuse 8 verwendete Material ist gegenüber Temperaturen von mindestens 850°C beständig, ohne in Brand zu geraten. Dies vermeidet, dass das Ladegerät in Brand gerät, wenn sich die im Kühlungsgehäuse 8 untergebrachte Elektronikkomponente 11₁ übermäßig aufheizt, z.B. wegen eines Defekts oder Überlastfalls.

In entsprechenden Realisierungen weist die Ladeelektronikeinheit 3, wie im gezeigten Beispiel, mindestens eine weitere Elektronikkomponente 11₂ auf, die sich außerhalb des Kühlungsgehäuses 8 befindet und schematisch z.B. in den Fig. 2, 3 und 9 zu erkennen ist. Bei dieser Elektronikkomponente 11₂ außerhalb des Kühlungsgehäuses 8 kann es sich beispielsweise um einen Mikrocontroller handeln, der im Betrieb nur eine geringe Wärmeentwicklung zeigt und daher nicht unbedingt von der Kühlluftströmung 5 gekühlt werden braucht. In alternativen Ausführungen befindet sich auch der Mikrocontroller innerhalb des Kühlungsgehäuses 8.

In entsprechenden Ausführungsformen umfasst die Ladeelektronikeinheit 3 ein Leistungselektronikteil und/oder ein Umschaltelektronikteil als die mindestens eine im Kühlungsgehäuse 8 angeordnete Elektronikkomponente 11₁. Im gezeigten Beispiel befinden sich sowohl ein Leistungselektronikteil 12 als auch ein Umschaltelektronikteil 13 jeweils herkömmlicher Bauart im Kühlungsgehäuse 8, wie sie in Fig.2 schematisch zu erkennen sind.

In vorteilhaften Ausführungen grenzt das Kühlungsgehäuse 8 mit seiner Kühlungsgehäuse-Luftauslassstruktur 10 an die Luftauslassstruktur 7 des Gerätegehäuses 1 an, wie dies auch beim gezeigten Beispiel der Fall ist und insbesondere aus Fig. 2 zu erkennen ist. In alternativen Ausführungen sind die Luftauslassstrukturen 10, 7 von Kühlungsgehäuse 8 und Gerätegehäuse 1 voneinander beabstandet angeordnet, so dass die Kühlluftströmung 5 nach Austritt aus dem Kühlungsgehäuse 8 zunächst noch im Gerätegehäuse 1 bis zu deren Luftauslassstruktur 7 strömt, bevor sie das Gerätegehäuse 1 verlässt.

In entsprechenden Realisierungen beinhaltet die Kühlungsgehäuse-Lufteinlassstruktur 9 mindestens zwei Lufteinlasszonen an zwei einander benachbarten Seitenbereichen des Kühlungsgehäuses 8. Dies ermöglicht einen in entsprechenden Anwendungen günstigen Lufteintritt in das Kühlungsgehäuse 8 an zwei benachbarten Gehäuseseiten. Im gezeigten Beispiel beinhaltet sie je eine Lufteinlasszone 9₁, 9₂ an zwei benachbarten Schmalseitenbereichen 8₁, 8₂ des Kühlungsgehäuses 8. In alternativen Ausführungen handelt es sich bei den zwei benachbarten Seitenbereichen um andere Seiten des Kühlungsgehäuses 8.

In entsprechenden Ausführungen weist das Kühlungsgehäuse 8, wie im gezeigten Beispiel, zwei gegenüberliegende Hauptseiten 8a, 8b und einen diese verbindenden Schmalseitenumfang 8c auf, wobei die Kühlungsgehäuse-Lufteinlassstruktur 9 und die Kühlungsgehäuse-Luftauslassstruktur 10 am Schmalseitenumfang 8c ausgebildet sind, d.h. an geeigneten Stellen des Umfangs um das Kühlungsgehäuse 8 herum zwischen den beiden gegenüberliegenden Hauptseiten 8a, 8b. Dadurch kann die Kühlluftströmung 5, wie aus Fig. 2 ersichtlich, über seine gesamte Strömungslänge im Kühlungsgehäuse 8 im Wesentlichen parallel zu den Hauptseiten 8a, 8b strömen, ohne in einer Richtung senkrecht zu den Hauptseiten 8a, 8b umgelenkt werden zu müssen. Dies ist in vielen Anwendungen für die Kühleffizienz der Kühlluftströmung 5 von Vorteil. Alternativ kann z.B. vorgesehen sein, dass die Lufteinlassstruktur 9 oder die Luftauslassstruktur 10 des Kühlungsgehäuses 8 an einer seiner beiden Hauptseiten 8a, 8b gebildet ist.

In vorteilhaften Ausführungsformen ist die im Kühlgehäuse 8 angeordnete Elektronickomponente 11₁ an einer von zwei gegenüberliegenden Hauptseiten des Kühlungsgehäuses 8 angeordnet. Speziell ist sie im gezeigten Beispiel an der in Fig. 3 hinteren Hauptseite 8b angeordnet. Dies ist insbesondere von Vorteil, wenn wie im gezeigten Beispiel die Ladeelektronikeinheit 3 eine Platinenbauform besitzt, d.h. eine oder mehrere Platinen 16₁, 16₂ aufweist, die mit den diversen Komponenten der Ladeelektronikeinheit 3bestückt ist/sind, da in diesem Fall die eine oder mehreren Platinen 16_{1,} 16₂ gleichzeitig als Wandung für die betreffende Hauptseite des Kühlungsgehäuses 8 beitragen können. In den meisten Fällen ist es hierbei günstig, wenn die einen oder mehreren Platinen 16_{1,} 16₂, wie im gezeigten Beispiel, an einer Trägerplatte 17 montiert sind, die das Kühlgehäuse 8 an der betreffenden Hauptseite 8b vollständig oder jedenfalls insoweit luftdicht abschließt, dass der Lufteintritt primär wie gewünscht über die Lufteinlassstruktur 9 mit der oder den betreffenden Lufteinlasszonen 9₁, 9₂ erfolgt und nicht durch größere Luftundichtigkeiten auf dieser Platinenseite des Kühlungsgehäuses 8 gestört wird. Die innenseitig an der oder den Platinen 16_{1,} 16₂ montierten Komponenten der Ladeelektronikeinheit 3 können dann effektiv von der Kühlluftströmung 5 gekühlt werden, soweit sie sich im Inneren des Kühlungsgehäuses 8 befinden. Der restliche Teil des Kühlungsgehäuses 8 bildet in diesem Fall eine Art Gehäusehaube, die mit der oder den Platinen 16_{1,} 16₂ bzw. deren Trägerplatte 17 vorzugsweise lösbar verbunden ist.

In entsprechenden Ausführungen weist die Kühlluftführungsstruktur 4, wie im gezeigten Beispiel, einen Lüfter 15 auf, der stromaufwärts oder stromabwärts angrenzend an die Kühlungsgehäuse-Luftauslassstruktur 10 angeordnet ist. Im gezeigten Beispiel sitzt der Lüfter 15 speziell im Luftauslassbereich des Kühlungsgehäuses 8, d.h. direkt stromaufwärts der Kühlungsgehäuse-Luftauslassstruktur 10, wie aus den Fig. 2 und 8 ersichtlich. In alternativen Ausführungen kann der Lüfter am Ladegerätgehäuse 1 im Bereich von deren Luftauslassstruktur 7 oder im Lufteintrittsbereich des Kühlungsgehäuses 8, d.h. stromaufwärts oder stromabwärts angrenzend an dessen Lufteinlassstruktur 9, positioniert sein.

In entsprechenden Realisierungen ist die Lufteinlassstruktur 6 des Gerätegehäuses 1 wie im gezeigten Beispiel als delokalisierte Lufteinlassstruktur ausgeführt und weist eine Mehrzahl von Lufteinlässen 18 auf, die an mindestens einem Seitenbereich, im gezeigten Beispiel an einer Unterseite 1a und an einer Oberseite 1b, des Gerätegehäuses 1 über dessen Bereichsausdehnung hinweg verteilt und/oder an mindestens zwei entgegengesetzten Seitenbereichen, im gezeigten Beispiel der Unterseite 1a und der Oberseite 1b, des Gerätegehäuses 1 gebildet sind. Hingegen ist im gezeigten Beispiel die Luftauslassstruktur 7 des Gerätegehäuses 1 als lokalisierte Luftauslassstruktur ausgeführt, indem sie durch eine einzige Luftauslassschlitzstruktur mit einer Mehrzahl eng benachbarter, paralleler Auslassschlitze gebildet ist.

In dieser Ausführung tritt folglich Kühlluft entsprechend delokalisiert an den relativ vielen über das Gerätegehäuse 1 verteilten Lufteintritten 18 in das Gerätegehäuse 1 ein, was eine entsprechend ungerichtete, diffuse Kühlluftströmung von der Lufteinlassstruktur 6 des Gerätegehäuses 1 bis zur Kühlungsgehäuse-Lufteinlassstruktur 9 zur Folge hat, während die Kühlluft über die Luftauslassstruktur 7 mit ihrer lokalisierten Luftauslassschlitzstruktur als gerichteter Kühlluftstrom aus dem Gerätegehäuse 1 austritt. In alternativen Ausführungen ist die Lufteinlassstruktur 6 des Gerätegehäuses 1 z.B. ähnlich wie im gezeigten Beispiel die Luftauslassstruktur 7 als lokalisierte Lufteinlassstruktur in Form einer oder mehrerer beabstandeter Lufteinlasszonen bzw. Lufteinlassschlitzstrukturen gebildet.

Zusätzlich kann die Lufteinlassstruktur 6 des Gerätegehäuses 1 Luftundichtigkeiten umfassen, die bewusst zwischen aneinandergrenzenden Gehäusewänden bzw. Gehäuseteilen des Gerätegehäuses 1 belassen sind. Im gezeigten Beispiel ist das Gerätegehäuse 1 aus einer unteren Gehäuseschale 19₁ und einer oberen Gehäuseschale 19₂ zusammengesetzt, und diese beiden Gehäuseschalen 19₁, 19₂ können unter Belassung von derartigen Luftundichtigkeiten zusammengebaut sein, beispielsweise unter Belassung von Wandungsspalten oder Labyrinthdichtungsbereichen zwischen den beiden Gehäuseschalenwandungen.

In entsprechenden Realisierungen befindet sich zumindest einer der Lufteinlässe, im gezeigten Beispiel sind dies eine Mehrzahl von Lufteinlässen 18₁, an einer in einer Gebrauchslage des Gerätegehäuses 1 unten liegenden Seite, im gezeigten Beispiel der Unterseite 1a, des Gerätegehäuses 1, wobei dieser jeweilige Lufteinlass 18₁ gleichzeitig eine Wasserauslassöffnung bildet, d.h. über diesen Lufteinlass 18₁ kann Wasser aus dem Gerätegehäuse 1 abfließen, wenn sich das Gerätegehäuse 1 in seiner z.B. in Fig. 1 gezeigten Gebrauchslage befindet. Für diese Zusatzfunktion als Wasserauslassöffnung ist der betreffende Lufteinlass 18₁ geeignet eingerichtet, insbesondere dadurch, dass er an der in Gebrauchslage des Gerätegehäuses 1 unten liegenden Gehäuseseite 1a an einer vorzugsweise möglichst tiefliegenden Wasserauslassstelle angeordnet ist, zu der in das Gerätegehäuse 1 eingedrungenes oder in ihm gebildetes Wasser durch entsprechende wasserleitende Gehäusestrukturen gelangen kann, um dort abgeführt werden zu können.

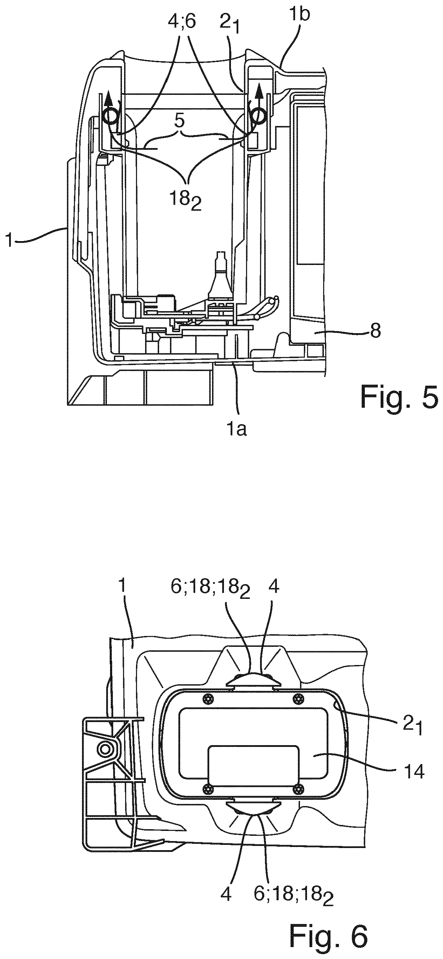

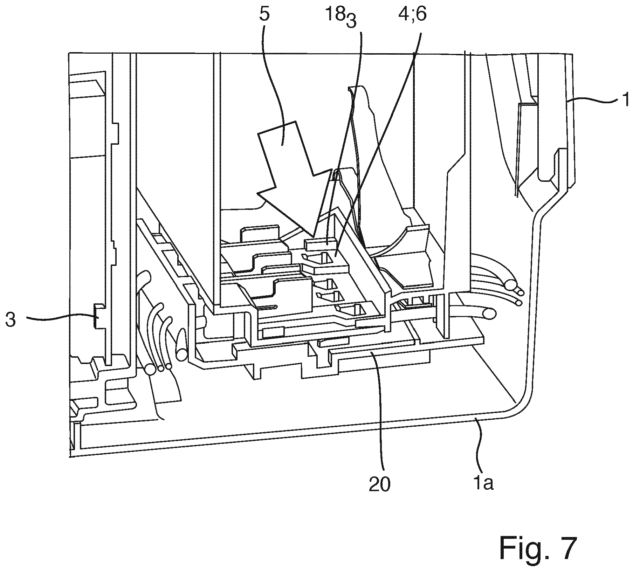

Weitere Lufteinlässe 18₂ sind im gezeigten Beispiel an Spaltbereichen im Eintrittsbereich des jeweiligen Batterieladeplatzes 2₁ bis 2₄ an der Oberseite 1b des Gerätegehäuses 1 gebildet, wie aus den Fig. 5 und 6 ersichtlich, z.B. im Bereich eines Sperrhebelmechanismus zum lösbaren Verriegen der in den jeweiligen Batterieladeplatz 2₁ bis 2₄ eingesetzten Batterieeinheit 14. Dabei sind die Batterieladeplätze bis 2₁ bis 2₄ im gezeigten Beispiel durch entsprechende Batterieschächte des Ladegehäuses 1 gebildet. Weiter sind im gezeigten Beispiel Lufteinlässe 18₃ in Form von Spaltbereichen in Kontaktplatten 20 an der Unterseite des jeweiligen Batterieladeplatzes 2₁ bis 2₄ bzw. Batterieschachtes ausgebildet, wie speziell aus Fig. 7 zu erkennen.

Wie die gezeigten und die weiteren oben erläuterten Ausführungsbeispiele deutlich machen, stellt die Erfindung ein Ladegerät zur Verfügung, das in vorteilhafter Weise eine Kühlluftführungsstruktur besitzt, die es ermöglicht, eine oder mehrere Elektronickomponenten einer Ladeelektronikeinheit in einem eigenen Kühlungsgehäuse innerhalb des Gerätegehäuses unterzubringen und dort effektiv mit einer Kühlluftströmung zu beaufschlagen. Das solchermaßen kühlungsoptimierte Ladegerät kann beispielsweise zum elektrischen Laden von Batterieeinheiten bzw. Akkupacks für Garten- und Forstbearbeitungsgeräte sowie Heimwerkergeräte bzw. Handwerkzeuggeräte verwendet werden.

## Patentansprüche

1. Ladegerät mit
- einem Gerätegehäuse (1) mit mindestens einem von außen zur Positionierung einer wiederaufladbaren Batterieeinheit zugänglichen Batterieladeplatz (21),
- einer Ladeelektronikeinheit (3) im Gerätegehäuse (1) zur Steuerung eines elektrischen Ladevorgangs für die am Batterieladeplatz (2₁) positionierte Batterieeinheit und
- einer Kühlluftführungsstruktur (4), die zur Führung einer Kühlluftströmung (5) von einer Lufteinlassstruktur (6) des Gerätegehäuses (1) über die Ladeelektronikeinheit (3) zu einer Luftauslassstruktur (7) des Gerätegehäuses (1) eingerichtet ist,
**dadurch gekennzeichnet, dass**
- die Kühlluftführungsstruktur (4) ein im Inneren des Gerätegehäuses (1) angeordnetes Kühlungsgehäuse (8) beinhaltet, das eine Kühlungsgehäuse-Lufteinlassstruktur (9) und eine Kühlungsgehäuse-Luftauslassstruktur (10) aufweist, und zur Führung der Kühlluftströmung (5) durch das Kühlungsgehäuse (8) hindurch von der Kühlungsgehäuse-Lufteinlassstruktur (9) zu der Kühlungsgehäuse-Luftauslassstruktur (10) und von dieser zur Luftauslassstruktur (7) des Gerätegehäuses (1) eingerichtet ist und
- die Ladeelektronikeinheit (3) mindestens eine im Kühlungsgehäuse (8) angeordnete Elektronikkomponente (11₁) aufweist.

2. Ladegerät nach Anspruch 1, weiter **dadurch gekennzeichnet, dass** die Kühlungsgehäuse-Lufteinlassstruktur (9) und die Kühlungsgehäuse-Luftauslassstruktur (10) jeweils lokal an zwei unterschiedlichen Seiten- oder Eckbereichen (8₁, 8₂) des Kühlungsgehäuses (8) ausgebildet sind.

3. Ladegerät nach Anspruch 1 oder 2, weiter **dadurch gekennzeichnet, dass** das Kühlungsgehäuse (8) brandschutzsicher ausgeführt ist.

4. Ladegerät nach einem der Ansprüche 1 bis 3, weiter **dadurch gekennzeichnet, dass** die Ladeelektronikeinheit (3) mindestens eine weitere Elektronikkomponente (11₂) aufweist, die sich außerhalb des Kühlungsgehäuses (8) befindet.

5. Ladegerät nach einem der Ansprüche 1 bis 4, weiter **dadurch gekennzeichnet, dass** die Ladeelektronikeinheit (3) ein Leistungselektronikteil (12) und/oder ein Umschaltelektronikteil (13) als im Kühlungsgehäuse (8) angeordnete Elektronickomponente (11₁) aufweist.

6. Ladegerät nach einem der Ansprüche 1 bis 5, weiter **dadurch gekennzeichnet, dass** das Kühlungsgehäuse (8) mit seiner Kühlungsgehäuse-Luftauslassstruktur (10) an die Luftauslassstruktur (7) des Gerätegehäuses (1) angrenzt.

7. Ladegerät nach einem der Ansprüche 1 bis 6, weiter **dadurch gekennzeichnet, dass** die Kühlungsgehäuse-Lufteinlassstruktur (9) zwei Lufteinlasszonen (9₁, 9₂) an zwei einander benachbarten Seitenbereichen des Kühlungsgehäuses (8) beinhaltet.

8. Ladegerät nach einem der Ansprüche 1 bis 7, weiter **dadurch gekennzeichnet, dass** das Kühlungsgehäuse (8) zwei gegenüberliegende Hauptseiten (8a, 8b) und einen diese verbindenden Schmalseitenumfang (8c) aufweist und die Kühlungsgehäuse-Lufteinlassstruktur (9) sowie die Kühlungsgehäuse-Luftauslassstruktur (10) am Schmalseitenumfang (8c) ausgebildet sind.

9. Ladegerät nach einem der Ansprüche 1 bis 8, weiter **dadurch gekennzeichnet, dass** die im Kühlungsgehäuse (8) angeordnete Elektronikkomponente (11₁) an einer von zwei gegenüberliegenden Hauptseiten (8a, 8b) des Kühlungsgehäuses (8) angeordnet ist.

10. Ladegerät nach einem der Ansprüche 1 bis 9, weiter **dadurch gekennzeichnet, dass** die Kühlluftführungsstruktur (4) einen Lüfter (15) aufweist, der stromaufwärts oder stromabwärts angrenzend an die Kühlungsgehäuse-Luftauslassstruktur (10) angeordnet ist.

11. Ladegerät nach einem der Ansprüche 1 bis 10, weiter **dadurch gekennzeichnet, dass** die Lufteinlassstruktur (6) des Gerätegehäuses (1) als delokalisierte Lufteinlassstruktur ausgeführt ist und eine Mehrzahl von Lufteinlässen (18) aufweist, die an mindestens einem Seitenbereich (1a) des Gerätegehäuses (1) über dessen Bereichsausdehnung hinweg verteilt und/oder an mindestens zwei entgegengesetzten Seitenbereichen (1a, 1b) des Gerätegehäuses (1) gebildet sind.

12. Ladegerät nach Anspruch 11, weiter **dadurch gekennzeichnet, dass** sich zumindest einer der Lufteinlässe an einer in einer Gebrauchslage des Gerätegehäuses (1) untenliegenden Seite (1a) des Gerätegehäuses (1) befindet und eine Wasserauslassöffnung bildet.

## Claims

1. Charger comprising
- a charger housing (1) having at least one battery-charging space (2₁) which is accessible from outside for positioning of a rechargeable battery unit,
- a charging electronics unit (3) in the charger housing (1) for controlling an electrical charging operation for the battery unit positioned on the battery-charging space (2₁), and
- a cooling-air-guiding structure (4) which is configured for guiding a cooling-air flow (5) from an air inlet structure (6) of the charger housing (1) via the charging electronics unit (3) to an air outlet structure (7) of the charger housing (1),
**characterized in that**
- the cooling-air-guiding structure (4) comprises a cooling housing (8) which is arranged in the interior of the charger housing (1) and has a cooling housing air inlet structure (9) and a cooling housing air outlet structure (10) and is configured for guiding the cooling-air flow (5) through the cooling housing (8) from the cooling housing air inlet structure (9) to the cooling housing air outlet structure (10) and from the latter to the air outlet structure (7) of the charger housing (1), and
- the charging electronics unit (3) comprises at least one electronic component (11₁) which is arranged in the cooling housing (8).

2. Charger according to Claim 1, further **characterized in that** the cooling housing air inlet structure (9) and the cooling housing air outlet structure (10) are each formed locally on two different side or corner regions (8₁, 8₂) of the cooling housing (8).

3. Charger according to Claim 1 or 2, further **characterized in that** the cooling housing (8) is formed fireproof.

4. Charger according to any one of Claims 1 to 3, further **characterized in that** the charging electronics unit (3) comprises at least one further electronic component (11₂) which is located outside the cooling housing (8).

5. Charger according to any one of Claims 1 to 4, further **characterized in that** the charging electronics unit (3) comprises a power electronics part (12) and/or a switchover electronics part (13) as the electronic component (11₁) arranged in the cooling housing (8).

6. Charger according to any one of Claims 1 to 5, further **characterized in that** the cooling housing (8) adjoins with its cooling housing air outlet structure (10) to the air outlet structure (7) of the charger housing (1).

7. Charger according to any one of Claims 1 to 6, further **characterized in that** the cooling housing air inlet structure (9) comprises two air inlet zones (9₁, 9₂) on two mutually adjacent side regions of the cooling housing (8).

8. Charger according to any one of Claims 1 to 7, further **characterized in that** the cooling housing (8) has two opposite main sides (8a, 8b) and a narrow side circumference (8c) connecting them, and the cooling housing air inlet structure (9) and the cooling housing air outlet structure (10) are formed on the narrow side circumference (8c).

9. Charger according to any one of Claims 1 to 8, further **characterized in that** the electronic component (11₁) which is arranged in the cooling housing (8) is arranged on one of two opposite main sides (8a, 8b) of the cooling housing (8).

10. Charger according to one of Claims 1 to 9, further **characterized in that** the cooling-air-guiding structure (4) comprises a fan (15) which is arranged adjacent upstream or downstream to the cooling housing air outlet structure (10).

11. Charger according to any one of Claims 1 to 10, further **characterized in that** the air inlet structure (6) of the charger housing (1) is designed as a delocalized air inlet structure and comprises a plurality of air inlets (18) which are distributed on at least one side region (1a) of the charger housing (1) throughout the extent of the area thereof and/or are formed on at least two opposite side regions (1a, 1b) of the charger housing (1).

12. Charger according to Claim 11, further **characterized in that** at least one of the air inlets is located on a bottom side (1a) of the charger housing (1) in a use position of the charger housing (1) and forms a water outlet opening.

## Revendications

1. Chargeur, comprenant
- un boîtier d'appareil (1) comprenant au moins un emplacement de charge de batterie (2₁) accessible depuis l'extérieur pour le positionnement d'une unité de batterie rechargeable,
- une unité d'électronique de charge (3) dans le boîtier d'appareil (1) pour commander un processus de charge électrique pour l'unité de batterie positionnée sur l'emplacement de charge de batterie (2₁), et
- une structure de guidage d'air de refroidissement (4) qui est aménagée pour guider un flux d'air de refroidissement (5) allant d'une structure d'entrée d'air (6) du boîtier d'appareil (1) à une structure de sortie d'air (7) du boîtier d'appareil (1) en passant par l'unité d'électronique de charge (3),
**caractérisé en ce que**
- la structure de guidage d'air de refroidissement (4) comporte un boîtier de refroidissement (8) disposé à l'intérieur du boîtier d'appareil (1), qui présente une structure d'entrée d'air de boîtier de refroidissement (9) et une structure de sortie d'air de boîtier de refroidissement (10), et qui est aménagée pour guider le flux d'air de refroidissement (5) à travers le boîtier de refroidissement (8) de la structure d'entrée d'air de boîtier de refroidissement (9) à la structure de sortie d'air de boîtier de refroidissement (10) et de celle-ci à la structure de sortie d'air (7) du boîtier d'appareil (1), et
- l'unité d'électronique de charge (3) présente au moins un composant électronique (11₁) disposé dans le boîtier de refroidissement (8).

2. Chargeur selon la revendication 1, en outre **caractérisé en ce que** la structure d'entrée d'air de boîtier de refroidissement (9) et la structure de sortie d'air de boîtier de refroidissement (10) sont respectivement réalisées localement au niveau de deux zones latérales ou d'angle (8₁, 8₂) différentes du boîtier de refroidissement (8).

3. Chargeur selon la revendication 1 ou 2, en outre **caractérisé en ce que** le boîtier de refroidissement (8) est réalisé de manière ignifuge.

4. Chargeur selon l'une quelconque des revendications 1 à 3, en outre **caractérisé en ce que** l'unité d'électronique de charge (3) présente au moins un autre composant électronique (11₂) qui se trouve à l'extérieur du boîtier de refroidissement (8).

5. Chargeur selon l'une quelconque des revendications 1 à 4, en outre **caractérisé en ce que** l'unité d'électronique de charge (3) présente une partie d'électronique de puissance (12) et/ou une partie d'électronique de commutation (13) en tant que composant électronique (11₁) disposé dans le boîtier de refroidissement (8).

6. Chargeur selon l'une quelconque des revendications 1 à 5, en outre **caractérisé en ce que** le boîtier de refroidissement (8) est adjacent par sa structure de sortie d'air de boîtier de refroidissement (10) à la structure de sortie d'air (7) du boîtier d'appareil (1) .

7. Chargeur selon l'une quelconque des revendications 1 à 6, en outre **caractérisé en ce que** la structure d'entrée d'air de boîtier de refroidissement (9) comporte deux zones d'entrée d'air (9₁, 9₂) sur deux zones latérales, voisines l'une de l'autre, du boîtier de refroidissement (8).

8. Chargeur selon l'une quelconque des revendications 1 à 7, en outre **caractérisé en ce que** le boîtier de refroidissement (8) présente deux faces principales (8a, 8b) opposées et une circonférence de petit côté (8c) qui les relie, et la structure d'entrée d'air de boîtier de refroidissement (9) ainsi que la structure de sortie d'air de boîtier de refroidissement (10) sont réalisées sur la circonférence de petit côté (8c).

9. Chargeur selon l'une quelconque des revendications 1 à 8, en outre **caractérisé en ce que** le composant électronique (11₁) disposé sur le boîtier de refroidissement (8) est disposé sur l'une de deux faces principales opposées (8a, 8b) du boîtier de refroidissement (8).

10. Chargeur selon l'une quelconque des revendications 1 à 9, en outre **caractérisé en ce que** la structure de guidage d'air de refroidissement (4) présente un aérateur (15) qui est disposé en amont ou en aval de manière adjacente à la structure de sortie d'air de boîtier de refroidissement (10).

11. Chargeur selon l'une quelconque des revendications 1 à 10, en outre **caractérisé en ce que** la structure d'entrée d'air (6) du boîtier d'appareil (1) est réalisée comme une structure d'entrée d'air délocalisée et présente une pluralité d'entrées d'air (18) qui sont réparties sur au moins une zone latérale (1a) du boîtier d'appareil (1) au-delà de l'étendue de zone de celui-ci et/ou sont formées sur au moins deux zones latérales opposées (1a, 1b) du boîtier d'appareil (1).

12. Chargeur selon la revendication 11, en outre **caractérisé en ce qu'**au moins l'une des entrées d'air se trouve sur une face (la) du boîtier d'appareil (1) située en bas dans une position d'utilisation du boîtier d'appareil (1) et constitue une ouverture d'évacuation d'eau.
